# EUROPÄISCHE PATENTSCHRIFT

(11) **EP 2 777 374 B1**
(45) Veröffentlichungstag und Bekanntmachung des Hinweises auf die Patenterteilung: **24.02.2016**
(21) Anmeldenummer: 12790476.1
(22) Anmeldetag: 09.11.2012
(51) Int. Cl.: H05K 9/00, H05K 7/14, H02G 3/08, H05K 5/02

(54) **GEHÄUSE FÜR FELDGERÄT**
HOUSING FOR FIELD DEVICE
BOÎTIER POUR APPAREIL DE TERRAIN

(30) Priorität: 11.11.2011 DE 102011086216
(43) Veröffentlichungstag der Anmeldung: 17.09.2014
(73) Patentinhaber: Endress+Hauser GmbH+Co. KG, 79689 Maulburg (DE)
(72) Erfinder: POL, Ioan Mircea, 79539 Lörrach (DE)
(74) Vertreter: Andres, Angelika Maria
(86) Internationale Anmeldenummer: PCT/EP2012/072232
(87) Internationale Veröffentlichungsnummer: WO 2013/068522

(56) Entgegenhaltungen:
- DE-U1- 29 608 312

## Beschreibung

Die Erfindung betrifft ein Feldgerät mit einem Gehäuse zur Aufnahme einer Elektronikeinheit, wobei das Gehäuse topfförmig ausgestaltet ist und aus einem nicht leitfähigen Material besteht, wobei an dem Gehäuse zumindest eine Leitungsdurchführung mit einem Gewinde vorgesehen ist und wobei die Leitungsdurchführung im Bereich des Gewindes mit einer leitfähigen Beschichtung versehen ist. Insbesondere bezieht sich die Erfindung auf ein Feldgerät zur Bestimmung oder Überwachung einer physikalischen oder chemischen Prozessgröße in der Automatisierungs-technik.

In der Automatisierungstechnik, insbesondere in der Prozess- und Fabrikautomatisierungstechnik, werden vielfach Feldgeräte eingesetzt, die zur Erfassung und/oder Beeinflussung von Prozessgrößen dienen. Zur Erfassung von Prozessgrößen dienen Sensoren, wie beispielsweise Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessvariablen Füllstand, Durchfluss, Druck, Temperatur, pH-Wert bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Im Zusammenhang mit der Erfindung werden unter Feldgeräten durchaus auch Remote I/Os, Funkadapter bzw. allgemein Geräte verstanden, die auf der Feldebene angeordnet sind und über einen Datenbus miteinander kommunizieren. Oftmals redet man in diesem Zusammenhang auch von Netzwerkkomponenten. Eine Vielzahl solcher Feldgeräte oder Netzwerkkomponenten wird von der Firma Endress + Hauser hergestellt und vertrieben.

Allerdings ist die Erfindung keineswegs auf Feldgeräte im zuvor beschriebenen Sinne beschränkt. Generell ist die Erfindung bei allen technischen Geräten einsetzbar, in denen die elektromagnetische Verträglichkeit (EMV) eine Rolle spielt. Die elektromagnetische Verträglichkeit kennzeichnet den erwünschten Zustand, dass technische Geräte sich nicht wechselseitig aufgrund von elektrischen oder elektromagnetischen Effekten stören. In anderen Worten ausgedrückt: Generell ist die Erfindung bei allen Geräten einsetzbar, bei den Komponenten (Gehäuse, Adapter, usw.) aus einem nicht leitfähigen Material über ein metallisiertes Gewinde elektrisch kontaktiert werden müssen.

Feldgeräte weisen üblicherweise ein Gehäuse zur Aufnahme einer Elektronikeinheit und einer Sensoreinheit auf. Das Gehäuse ist topfförmig ausgestaltet und ist in vielen Fällen aus einem nicht leitfähigen Material gefertigt. Als Materialien werden Kunststoffe oder Verbundwerkstoffe verwendet. Weiterhin ist an dem Gehäuse zumindest eine Leitungsdurchführung mit einem Gewinde vorgesehen, durch die die elektrischen Leitungen aus dem Gehäuse herausgeführt werden. Um eine statische Aufladung des Gehäuses zu vermeiden, sind zumindest die Innenflächen des Gehäuses und der Leitungsdurchführung mit Gewinde mit einer leitfähigen Beschichtung versehen.

Bei der Metallisierung bzw. bei der Beschichtung mit einem leitfähigen Material setzen sich die Partikel nicht gleichmäßig und durchgängig in den Gewindegängen einer Durchführung ab. Als Folge davon entsteht längs des Gewindegangs der Durchführung ein spiralförmiger Pfad, der den Weg, den die elektrischen Ladungen im Bereich der Durchführung nehmen, erheblich verlängert. Die Verlängerung des elektrischen Wegs führt automatisch zu einer Vergrößerung des Widerstands zwischen zwei Messpunkten, bei denen sich ein Messpunkt innerhalb des Gehäuses und der andere Messpunkt außerhalb des Gehäuses befindet. Dies ist bei der Ableitung unerwünschter Ladungen natürlich nachteilig.

Bislang wurde dieses Problem dadurch gelöst, dass die Erdung des Feldgeräts über ein Zusatzteil, z.B. ein Überbrückungsschwert oder ein Kontaktierungsblech sichergestellt wurde. Die entsprechenden Zusatzteile bringen die folgenden Nachteile mit sich: Logistikaufwand, Materialpflege, Montageaufwand, Dichtigkeitsprobleme, zusätzlicher Kosten- und Zeitaufwand, unsaubere Optik, Risiko, dass sich Verunreinigungen ansammeln, Verletzungsrisiko, usw.

DE 296 08 312 U1 beschreibt ein Gehäuse aus Kunststoff für elektrische und elektronische Bauteile, mit einem kastenförmigen Unterteil und einem kastenförmigen Deckel und einer im Unterteil und Deckel vorgesehenen Abschirmung für die eingebrachten Bauteile gegen elektromagnetische Felder und Strahlungen. Bei derartigen bekannten Kunststoffgehäusen ist die Abschirmung von einer metallischen Beschichtung gebildet, die in das Gehäuseunterteil und den Gehäusedeckel eingebracht wird.

Der Erfindung liegt die Aufgabe zugrunde, den Aufwand für die Erdung eines Feldgeräts zu reduzieren.

Die Erfindung wird dadurch gelöst, dass das Gewinde in zumindest einem in axialer Richtung zur Leitungsdurchführung verlaufenden Bereich zumindest eine Nut aufweist. Wie bereits zuvor erwähnt, ist das Gehäuse aus einem nicht leitfähigen Material, insbesondere einem Kunststoff oder einem Verbundwerkstoff gefertigt.

Eine vorteilhafte Weiterbildung des erfindungsgemäßen Feldgeräts schlägt vor, dass die Nut bzw. die Nuten zumindest die gleiche Tiefe aufweist/ aufweisen, wie die Tiefe des Gewindegangs des Gewindes. Hierdurch lässt sich der Einfluss eines erhöhten Widerstands infolge des verlängerten Stromwegs durch den Gewindegang eliminieren. In der bevorzugten Ausgestaltung sind an jeder Leitungsdurchführung des Feldgeräts aus Redundanzüberlegungen heraus zumindest zwei Nuten vorgesehen: Tritt im Bereich einer Nut eine Störung des Stromwegs auf, so erfolgt die Ableitung der unerwünschten Ladungen aufgrund des geringeren Widerstands über die zweite Nut.

Das Gehäuse mit Nuten im Bereich einer Durchführung kann beispielsweise über ein Spritzgussverfahren hergestellt werden. Möglich sind weiterhin Umformverfahren oder alternative Fertigungsverfahren. In einer weiteren Ausgestaltung ist vorgesehen, dass die Nut bzw. die Nuten durch nachträgliche Bearbeitung im Bereich des Gewindes eingearbeitet wird bzw. eingearbeitet werden.

Zusammengefasst weist das erfindungsgemäße Feldgerät die folgenden Vorteile auf:
- es werden keine zusätzlichen Komponenten, wie Überbrückungsteile zur Erdung benötigt;
- der Logistikaufwand wird minimiert;
- die Materialpflege wird minimiert;
- der Montageaufwand wird minimiert;
- Dichtigkeitsprobleme entfallen;
- der Zeitaufwand zur Montage wird reduziert;
- die Kosten werden reduziert;
- die Optik ist sauber;
- das Schmutzansammlungsrisiko entfällt;
- das Verletzungsrisiko z.B. beim Einsatz eines Überbrückungsschwerts entfällt.

Die Erfindung wird anhand der nachfolgenden Figuren näher erläutert. Es zeigt:
Fig. 1: eine perspektivische Ansicht des Gehäuses eines Feldgeräts, bei dem die Erfindung zum Einsatz kommt, und
Fig. 2: den mit B gekennzeichneten vergrößerten Ausschnitt aus Fig. 1.

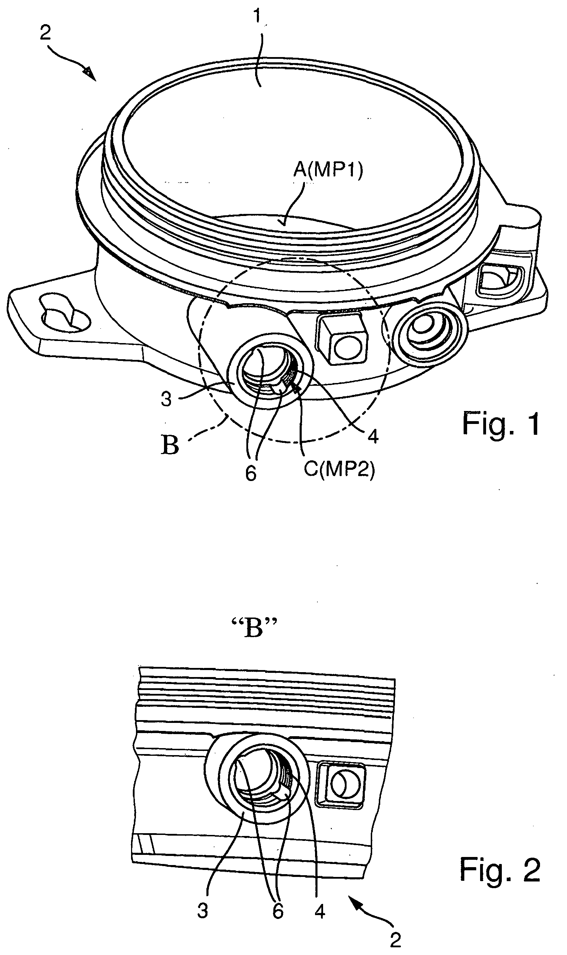

Fig. 1 zeigt eine perspektivische Ansicht des Gehäuses 2 eines Feldgeräts, bei dem die Erfindung zum Einsatz kommt. Was unter den Begriff Feldgerät zu subsumieren ist, wurde bereits an vorhergehender Stelle eingehend erläutert.

Das Gehäuse 2 des in der Fig. 1 nicht gesondert dargestellten Feldgeräts dient zur Aufnahme einer nicht gesondert dargestellten Elektronikeinheit. Eine Sensoreinheit zur Bestimmung und/oder Überwachung einer Prozessgröße in der Automatisierungstechnik ist entweder an dem Gehäuse 2 unmittelbar befestigt (Kompaktsensor), oder Sensoreinheit und Elektronikeinheit sind getrennt ausgeführt und voneinander über eine Kabelverbindung abgesetzt. Das Gehäuse 2 ist im Wesentlichen topfförmig ausgestaltet und ist aus einem nicht leitfähigen Material gefertigt. Insbesondere besteht das Gehäuse 2 aus einem Kunststoff oder einem Verbundwerkstoff.

Bezug nehmend auf Fig. 1 ist an dem Gehäuse 2 eine Leitungsdurchführung 3 mit jeweils einem Innengewinde 4 vorgesehen. Selbstverständlich gelten die nachfolgenden Aussagen auch im Falle eines Außengewindes. Im gezeigten Fall sind die Innenfläche des Gehäuses 2 und die Innenfläch der Leitungsdurchführung 3 im Bereich des Gewindes 4 mit einer leitfähigen Beschichtung 5 versehen. Hierbei tritt das Problem auf, dass sich die MetallPartikel bei der Metallisierung bzw. bei der Beschichtung mit einem leitfähigen Material im Bereich des Gewindegangs eines Gewindes 4 nicht gleichmäßig und durchgängig absetzen. Als Folge davon entsteht längs des Gewindegangs des Gewindes 4 der Leitungsdurchführung 3 ein spiralförmiger Pfad, der den Weg, den die elektrischen Ladungen im Bereich der Leitungsdurchführung 3 ggf. nehmen müssen, erheblich verlängert. Die Verlängerung des Weges der Ladungen führt automatisch zu einer Vergrößerung des Widerstands zwischen den in Fig. 1 beispielhaft gezeigten Messpunkten A(MP1), C(MP2) am Gehäuse 2. Diese Vergrößerung des Widerstands ist bei der Ableitung unerwünschter Ladungen natürlich nachteilig.

Erfindungsgemäß weist das Gewinde 4 der Leitungsdurchführung 3 zwecks Verbesserung und Vereinfachung der Erdung des Feldgeräts in zumindest einem in axialer Richtung zur Leitungsdurchführung 3 verlaufenden Bereich eine Nut 6 auf. Bevorzugt ist die Nut 6 parallel zur Längsachse der Leitungsdurchführung 3 angeordnet. Im gezeigten Fall, weist das Gewinde 4, wie in dem vergrößerten Ausschnitt B aus Fig. 1, der in Fig. 2 zu sehen ist, zwei Nuten 6 auf. Durch diese Ausgestaltung mit zwei Nuten 6 lässt sich eine Redundanz erreichen, fällt der Weg über eine Nut 6 aus, so können die Ladungen noch den Weg über die redundante zweite Nut 6 nehmen. Die Nut 6 bzw. die Nuten 6 weist bzw. weisen zumindest die gleiche Tiefe auf wie die Tiefe des Gewindegangs des Gewindes 4. Ist diese Bedingung erfüllt, so wird der Effekt des Gewindeganges, durch den der Widerstand im Bereich des Gewindegangs erhöht wird, vollständig eliminiert. Durch die Erfindung wird die EMV Performance eines Feldgeräts folglich erheblich verbessert.

## Patentansprüche

1. Feldgerät mit einem Gehäuse (2) zur Aufnahme einer Elektronikeinheit wobei das Gehäuse (2) topfförmig ausgestaltet ist und aus einem nicht leitfähigen Material besteht,
**dadurch gekennzeichnet,**
**dass** an dem Gehäuse (2) zumindest eine Leitungsdurchführung (3) mit einem Gewinde (4) vorgesehen ist, wobei die Leitungsdurchführung (3) im Bereich des Gewindes (4) mit einer leitfähigen Beschichtung (5) versehen ist, und wobei das Gewinde (4) in zumindest einem in axialer Richtung zur Leitungsdurchführung (3) verlaufenden Bereich zumindest eine Nut (6) aufweist.

2. Feldgerät nach Anspruch 1,
wobei das Gehäuse (2) aus Kunststoff oder einem Verbundwerkstoff gefertigt ist.

3. Feldgerät nach Anspruch 1,
wobei die Nut (6) bzw. die Nuten (6) zumindest die gleiche Tiefe aufweist/ aufweisen, wie die Tiefe des Gewindegangs des Gewindes (4).

4. Feldgerät nach Anspruch 1, 2 oder 3,
wobei an der Leitungsdurchführung (3) zumindest zwei Nuten (6) vorgesehen sind.

5. Feldgerät nach einem oder mehreren der vorhergehenden Ansprüche,
wobei das Gehäuse (2) über ein Spritzgussverfahren, ein Umformverfahren oder ein alternatives Fertigungsverfahren hergestellt ist.

6. Feldgerät nach einem oder mehreren der vorhergehenden Ansprüche,
wobei die Nut (6) bzw. die Nuten (6) durch nachträgliche Bearbeitung in das Gewinde (4) eingearbeitet ist/sind.

## Claims

1. Field device with a housing (2) designed to accommodate an electronics unit,
wherein the housing (2) is designed in the shape of a pot and is made from a nonconductive material,
**characterized in that**
at least one cable entry (3) with a thread (4) is provided on the housing (2), wherein the cable entry (3) is provided with a conductive coating (5) in the area of the thread (4), and wherein the thread (4) has at least one groove (6) in at least one area extending in the axial direction in relation to the cable entry (3).

2. Field device as claimed in Claim 1,
wherein the housing (2) is made from plastic or a composite material.

3. Field device as claimed in Claim 1,
wherein the groove (6) or grooves (6) has/have at least the same depth as the thread run of the thread (4).

4. Field device as claimed in Claims 1, 2 or 3,
wherein at least two grooves (6) are provided on the cable entry (3).

5. Field device as claimed in one or more of the previous claims,
wherein the housing (2) is manufactured via an injection molding process, a forming process or an alternative manufacturing process.

6. Field device as claimed in one or more of the previous claims,
wherein the groove (6) or grooves (6) is/are incorporated into the thread (4) by subsequent machining.

## Revendications

1. Appareil de terrain avec un boîtier (2) destiné à la réception d'une unité électronique, le boîtier (2) étant conçu en forme de pot et étant constitué d'un matériau non conducteur,
**caractérisé**
**en ce qu'**est prévu sur le boîtier (2) au moins un passage de câble (3) avec un taraudage (4), le passage de câble (3) étant muni dans la zone du taraudage (4) d'un revêtement conducteur (5), et le taraudage (4) présentant au moins une rainure (6) dans une zone s'étendant dans une direction axiale par rapport au passage de câble (3).

2. Appareil de terrain selon la revendication 1,
pour lequel le boîtier (2) est fabriqué en matière plastique ou en un matériau composite.

3. Appareil de terrain selon la revendication 1,
pour lequel la rainure (6) ou les rainures (6) présente(nt) au moins la même profondeur que la profondeur du pas du taraudage (4).

4. Appareil de terrain selon la revendication 1, 2 ou 3,
pour lequel au moins deux rainures (6) sont prévues sur le passage de câble (3).

5. Appareil de terrain selon l'une ou plusieurs des revendications précédentes, pour lequel le boîtier (2) est fabriqué au moyen d'un procédé de moulage par injection, d'un procédé de formage ou d'un procédé de fabrication alternatif.

6. Appareil de terrain selon l'une ou plusieurs des revendications précédentes, pour lequel la rainure (6) ou les rainures (6) est/sont incorporée(s) par un traitement ultérieur dans le filetage (4).
